# EUROPEAN PATENT APPLICATION

(11) **EP 4 826 402 A1**
(43) Date of publication of application: **21.10.2026**
(21) Application number: 24902141.1
(22) Date of filing: 06.08.2024
(51) Int. Cl.: G01R 31/382

(54) **BATTERY CAPACITY DETERMINATION METHOD AND BATTERY STATE-OF-HEALTH DETERMINATION METHOD**

(30) Priority: 15.12.2023 CN 202311738482
(71) Applicant: BYD Company Limited, Shenzhen, Guangdong 518118 (CN)
(72) Inventor: FENG, Tianyu, Shenzhen, Guangdong 518118 (CN); LI, Xiaoqian, Shenzhen, Guangdong 518118 (CN); CAO, Huili, Shenzhen, Guangdong 518118 (CN)
(74) Representative: Mathys & Squire
(86) International application number: PCT/CN2024/110204
(87) International publication number: WO 2025/123715

(57) **Abstract**

A battery capacity determination method, including: (S1) when the initial static voltage of a battery from which charging starts is less than or equal to a preset voltage threshold value, on the basis of an initial residual capacity corresponding to the initial static voltage and a first capacity charged into the battery from the initial static voltage to a high-voltage inflection point, updating the high-voltage inflection point capacity of the battery to obtain the current high-voltage inflection point capacity of the battery; and (S2), on the basis of the current high-voltage inflection point capacity, determining the current maximum capacity of the battery.

## Description

### CROSS-REFERENCE TO RELATED APPLICATIONS

The present disclosure claims priority to Chinese Patent disclosure No. 202311738482.6 filed on December 15, 2023, the entire contents of which are incorporated herein by reference.

### FIELD

The present disclosure relates to the field of new energy, and in particular, to a battery capacity determination method, a battery state-of-health determination method, a computer program product, a processor, a power distribution box, a BMS system, and an electrical apparatus.

### BACKGROUND

With the rapid development of the automotive industry, new energy vehicles have gradually attracted increasing attention. Compared with traditional automobiles, new energy vehicles emit fewer harmful pollutants, particularly electric vehicles. The power source of an electric vehicle is a battery, which can convert chemical energy into electrical energy to drive a motor to operate the vehicle. The state-of-health (SOH) of the battery is an important parameter for evaluating safety, reliability, and power performance of electric vehicles.

In the related art, it is usually necessary to calculate battery capacity by determining the high-voltage inflection point of a battery charging curve using offline data. However, when battery cells have initial differences or age, the high-voltage inflection point of the battery charging curve may change. Therefore, calculating the battery capacity using offline battery data may result in significant errors.

### SUMMARY

The present disclosure aims to solve at least one of the technical problems in the related art to a certain extent. To this end, an objective of the present disclosure is to provide a battery capacity determination method, which has the advantage of improving the accuracy of determined battery capacity.

According to a first aspect of an embodiment of the present disclosure, the present disclosure provides a battery capacity determination method, including:
when an initial static voltage of a battery from which charging starts is less than or equal to a preset voltage threshold value, according to an initial residual capacity corresponding to the initial static voltage and a first capacity charged into the battery from the initial static voltage to a high-voltage inflection point, the high-voltage inflection point capacity of the battery being updated to obtain the current high-voltage inflection point capacity of the battery; and
according to the current high-voltage inflection point capacity, a current maximum capacity of the battery being determined.

In an embodiment of the present disclosure, the high-voltage inflection point capacity of the battery being updated according to an initial residual capacity corresponding to the initial static voltage and a first capacity charged into the battery from the initial static voltage to a high-voltage inflection point includes:
the initial residual capacity being acquired;
a previous maximum capacity of the battery being acquired; and
the current high-voltage inflection point capacity being determined according to the previous maximum capacity, the initial residual capacity, and the first capacity.

In an embodiment of the present disclosure, the current high-voltage inflection point capacity being determined according to the previous maximum capacity, the initial residual capacity, and the first capacity includes:
a product of the previous maximum capacity and the initial residual capacity being calculated;
a first sum of the product and the first capacity being calculated; and
the first sum being taken as the current high-voltage inflection point capacity.

In an embodiment of the present disclosure, the current maximum capacity of the battery being determined according to the current high-voltage inflection point capacity includes:
a second capacity being acquired charged into the battery from the high-voltage inflection point to full charge; and
the current maximum capacity being determined according to the second capacity and the current high-voltage inflection point capacity.

In an embodiment of the present disclosure, the method further includes:
when the initial static voltage is greater than the preset voltage threshold, the current maximum capacity being determined according to a previous high-voltage inflection point capacity of the battery.

In an embodiment of the present disclosure, before updating the high-voltage inflection point capacity of the battery according to the initial residual capacity corresponding to the initial static voltage and the first capacity charged into the battery from the initial static voltage to the high-voltage inflection point to obtain the current high-voltage inflection point capacity of the battery, the method further includes:
a voltage-capacity curve of the battery being acquired during a charging process;
a filtered voltage-capacity curve being obtained by performing smoothing filtering on the voltage-capacity curve ;
a differential voltage-capacity curve being obtained by performing a differential operation on the voltage-capacity curve; and
a peak value of the differential voltage-capacity curve being acquired, and the high-voltage inflection point being determined according to the peak value.

In an embodiment of the present disclosure, the high-voltage inflection point being determined according to the peak value includes:
a peak voltage being acquired corresponding to the peak value from the voltage-capacity curve;
a maximum value of the peak voltage being acquired; and
the maximum value being taken as the high-voltage inflection point.

According to a second aspect of an embodiment of the present disclosure, the present disclosure provides a battery state-of-health determination method, applied to the battery capacity determination method according to any one of the first aspect, including:
a current maximum capacity of a battery being determined by a battery capacity determination method according to any one of the first aspect; and
a state-of-health of the battery being determined according to a ratio of the current maximum capacity to an initial capacity of the battery.

According to a third aspect of an embodiment of the present disclosure, the present disclosure provides a computer program product including instructions, which when the computer program product runs on a computer, the battery capacity determination method according to any one of the first aspect or the battery state-of-health determination method according to the second aspect being executed by the computer.

According to a fourth aspect of an embodiment of the present disclosure, the present disclosure provides a processor, the processor being configured to execute instructions to implement the battery capacity determination method according to any one of the first aspect or the battery state-of-health determination method according to the second aspect.

According to a fifth aspect of an embodiment of the present disclosure, the present disclosure provides a power distribution box, including the processor according to the third aspect.

According to a sixth aspect of an embodiment of the present disclosure, the present disclosure provides a BMS system, including the power distribution box according to the fifth aspect, and/or including the processor according to the fifth aspect.

According to a seventh aspect of an embodiment of the present disclosure, the present disclosure provides an electrical apparatus, including the BMS system according to the sixth aspect.

In the battery capacity determination method according to the embodiment of the present disclosure, when the initial static voltage of a battery from which charging starts is less than or equal to a preset voltage threshold value, a high-voltage inflection point capacity of the battery is updated according to an initial residual capacity corresponding to the initial static voltage and a first capacity charged into the battery from the initial static voltage to a high-voltage inflection point, thereby the current high-voltage inflection point capacity of the battery is obtained; and the current maximum capacity of the battery is determined according to the current high-voltage inflection point capacity, avoiding the problem of large errors in calculating battery capacity using offline battery data, thereby greatly improving the accuracy of the determined battery capacity.

Additional aspects and advantages of the present disclosure will be set forth in part in the description which follows, and in part will be obvious from the description, or may be learned by practice of the disclosure_{∘}

### BRIEF DESCRIPTION OF THE DRAWINGS

FIG. 1 is a flowchart of a battery capacity determination method according to an embodiment;
FIG. 2 is a schematic diagram of a voltage-capacity curve according to an embodiment;
FIG. 3 is a schematic diagram of a differential voltage-capacity curve according to an embodiment;
FIG. 4 is a flowchart of a battery state-of-health determination method according to an embodiment;
FIG. 5 is a schematic diagram of a computer program product according to an embodiment.
FIG. 6 is a block diagram of an electrical apparatus according to an embodiment.

### DETAILED DESCRIPTION

The embodiments of the present disclosure are described below in detail. Examples of the embodiments are shown in the accompanying drawings, wherein the same or similar reference numerals refer to the same or similar elements or elements having the same or similar functions throughout. The embodiments described below with reference to the accompanying drawings are exemplary and are intended to explain the present disclosure and will not be construed as limiting the present disclosure.

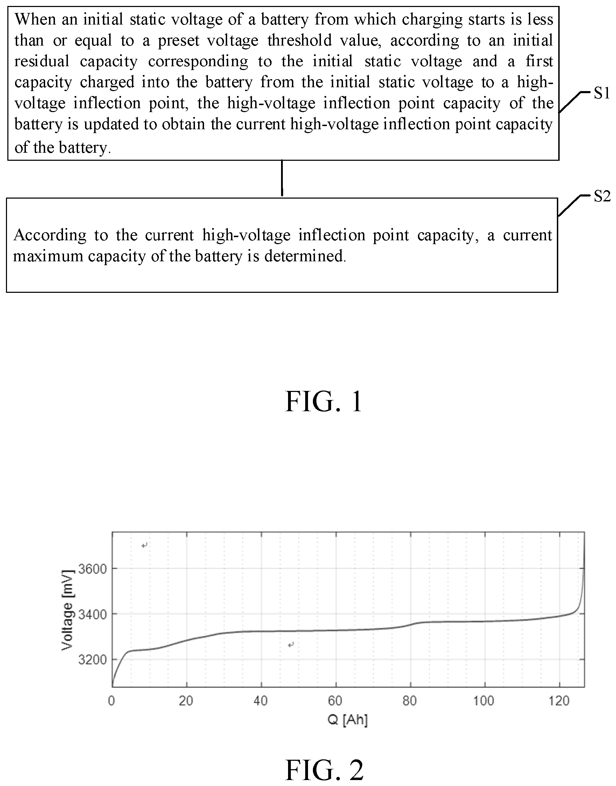

A battery capacity determination method according to the embodiment of the present disclosure will be described below with reference to the accompanying drawings. Referring to FIG. 1, the battery capacity determination method may include the following steps:
S1. when an initial static voltage of a battery from which charging starts is less than or equal to a preset voltage threshold value, according to an initial residual capacity corresponding to the initial static voltage and a first capacity charged into the battery from the initial static voltage to a high-voltage inflection point, the high-voltage inflection point capacity of the battery is updated to obtain the current high-voltage inflection point capacity of the battery; and
S2. according to the current high-voltage inflection point capacity, a current maximum capacity of the battery is determined.

In summary, in the battery capacity determination method according to the embodiment of the present disclosure, when the initial static voltage of a battery from which charging starts is less than or equal to a preset voltage threshold value, according to an initial residual capacity corresponding to the initial static voltage and a first capacity charged into the battery from the initial static voltage to a high-voltage inflection point, the high-voltage inflection point capacity of the battery is updated to obtain the current high-voltage inflection point capacity of the battery; according to the current high-voltage inflection point capacity, a current maximum capacity of the battery is determined, avoiding the problem of large errors in calculating battery capacity using offline battery data, thereby greatly improving the accuracy of the determined battery capacity.

Next, each step in the battery capacity determination method in the embodiment of the present disclosure will be described in more detail with reference to the accompanying drawings and embodiments.

In S1, when an initial static voltage of a battery from which charging starts is less than or equal to a preset voltage threshold value, according to an initial residual capacity corresponding to the initial static voltage and a first capacity charged into the battery from the initial static voltage to a high-voltage inflection point, the high-voltage inflection point capacity of the battery is updated to obtain the current high-voltage inflection point capacity of the battery.

How to determine the first capacity charged into the battery from the initial static voltage to the high-voltage inflection point is explained below.

In an embodiment of the present disclosure, the battery may be a lithium-ion battery. The embodiment of the present disclosure will be described below by taking a lithium iron phosphate lithium-ion battery, which is a type of lithium-ion battery, as an example.

In an embodiment of the present disclosure, after the lithium iron phosphate lithium-ion battery is discharged, it may be left standing for a period of time, for example, two hours, and then charging of the lithium iron phosphate lithium-ion battery may be started, and the initial static voltage of the lithium iron phosphate lithium-ion battery may be acquired.

In an embodiment of the present disclosure, the smaller the measured static voltage of the lithium iron phosphate lithium-ion battery, the closer the capacity of the lithium iron phosphate lithium-ion battery calculated according to the voltage at this time is to the actual capacity, which means, the more accurate the determined capacity of the lithium iron phosphate lithium-ion battery is. Therefore, the acquired first capacity charged into the lithium iron phosphate lithium-ion battery from the current voltage to the high-voltage inflection point is also more accurate, and further updating the current high-voltage inflection point capacity of the battery according to the first capacity is also more accurate, thereby obtaining more accurate data. In an embodiment of the present disclosure, the charging duration and charging current when the lithium iron phosphate lithium-ion battery is charged from the current voltage to the high-voltage inflection point may be acquired, and then the ampere-hour integration method may be used to calculate the first capacity charged into the lithium iron phosphate lithium-ion battery from the current voltage to the high-voltage inflection point. The ampere-hour integration method is a basic method for battery power measurement, which uses a current-time accumulation method to estimate the state of charge of a dynamic lithium battery in real time. The calculation formula of the ampere-hour integration method is as follows:
$SOC \left(t\right) = {SOC}_{0} + {\int }_{0}^{t} I \left(t\right) dt / CE$ (1)
wherein, *SOC*₀ is the initial power value of the battery state of charge; CE is the rated capacity of the battery; I(t) is the charging/discharging current of the battery at time t; t is the charging/discharging time. The ampere-hour integration method is relatively less limited by the condition of battery itself, and the calculation method is simple and reliable, enabling real-time estimation of the state of charge of the battery.

How to determine the high-voltage inflection point of the lithium iron phosphate lithium-ion battery is explained below.

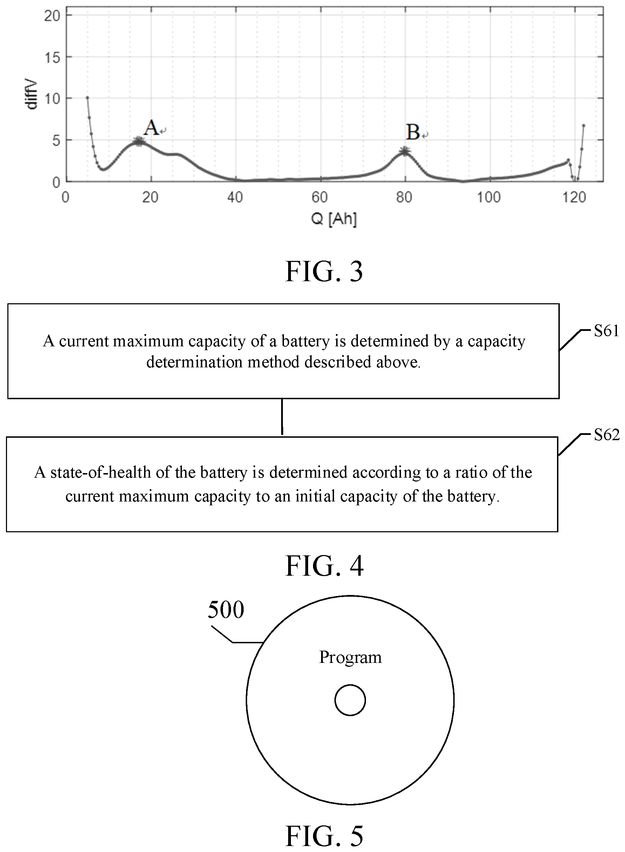

According to the above, in an embodiment of the present disclosure, before updating the high-voltage inflection point capacity of the battery according to the initial residual capacity corresponding to the initial static voltage and the first capacity charged into the battery from the initial static voltage to the high-voltage inflection point to obtain the current high-voltage inflection point capacity of the battery, the method further comprises:
S31. acquiring a voltage-capacity curve of the battery during a charging process;
S32. obtaining a filtered voltage-capacity curve by performing smoothing filtering on the voltage-capacity curve;
S33. obtaining a differential voltage-capacity curve by performing a differential operation on the voltage-capacity curve,
generally speaking, a voltage-capacity curve of a lithium-ion battery during charging and discharging processes has an interval where the voltage changes relatively slowly, which is called a voltage plateau region. During the transition between two different plateau regions, there exists a point where the voltage changes fastest, called an inflection point. Three such voltage plateau regions exist for a lithium iron phosphate battery, and so there are two inflection points. Differentiated by voltage level, the inflection point with a higher voltage is marked as a high-voltage inflection point (HVTP), and the inflection point with a lower voltage is marked as a low-voltage inflection point (LVTP), and
in an embodiment of the present disclosure, before the lithium iron phosphate lithium-ion battery leaves the factory, the lithium iron phosphate lithium-ion battery may be discharged to a cut-off voltage (SOC=0%), then the lithium iron phosphate lithium-ion battery is charged, and the voltage-capacity curve during the charging process of the lithium iron phosphate lithium-ion battery is recorded. An example of the recorded voltage-capacity curve is shown in FIG. 2. Further, smoothing filtering is performed on the voltage-capacity curve to obtain a filtered voltage-capacity curve. Then, a differential of the voltage with respect to the capacity is calculated for the filtered voltage-capacity curve to obtain a differential voltage-capacity curve, such as the one shown in FIG. 3; and
S34. acquiring a peak value of the differential voltage-capacity curve, and determining the high-voltage inflection point according to the peak value.

In an embodiment of the present disclosure, a peak voltage corresponding to the peak value is acquired from the voltage-capacity curve; a maximum value of the peak voltage is acquired; and the maximum value is taken as the high-voltage inflection point.

As shown in FIG. 3, there are two peak values obtained from the differential voltage-capacity curve, namely point A on the left and point B on the right. The peak voltage corresponding to point B in the voltage-capacity curve is greater than the peak voltage corresponding to point A in the voltage-capacity curve, so the peak voltage at point B is taken as the high-voltage inflection point (HVTP) of the battery, and the peak voltage at point A is taken as the low-voltage inflection point (LVTP) of the battery.

According to the content, in an embodiment of the present disclosure, before updating the high-voltage inflection point capacity of the battery according to the initial residual capacity corresponding to the initial static voltage and the first capacity charged into the battery from the initial static voltage to the high-voltage inflection point, the method further comprises:
S41. acquiring the initial residual capacity, and
in an embodiment of the present disclosure, the initial residual capacity may be acquired using Relaxation Voltage Correction (RVC). Specifically, after acquiring the initial static voltage of the lithium iron phosphate lithium-ion battery, an initial residual capacity SOC_{low} corresponding to the initial static voltage is obtained by looking up a table of battery voltage versus state of charge (SOC), or
in another embodiment of the present disclosure, the initial residual capacity SOC_{low} may also be acquired by a Kalman filtering method. The Kalman filtering method is a method of building an equivalent circuit model of resistors and capacitors, and then inputting real-time voltage values into the circuit model to predict the state of charge of a battery pack in real time under dynamic conditions. Therefore, by inputting the initial static voltage into this circuit model, the initial residual capacity SOC_{low} can be obtained. Since the accuracy is higher in states where the voltage change is more obvious during discharge, when the voltage is below the low voltage inflection point, the Kalman filtering method can also accurately predict the SOC state, and thus the initial residual capacity SOC_{low} corresponding to the initial static voltage can be accurately obtained using the Kalman filtering method, thereby obtaining the high-voltage inflection point capacity more accurately;
S42. acquiring a previous maximum capacity of the battery,
in an embodiment of the present disclosure, a previous maximum capacity Qₗₐₛₜ of the lithium iron phosphate lithium-ion battery after the last update of the high-voltage inflection point capacity is acquired; and
S43. determining the current high-voltage inflection point capacity according to the previous maximum capacity, the initial residual capacity, and the first capacity.

According to the content, in an embodiment of the present disclosure, the determining the current high-voltage inflection point capacity according to the previous maximum capacity, the initial residual capacity, and the first capacity comprises:
S431. calculating a product of the previous maximum capacity and the initial residual capacity;
S432. calculating a first sum of the product and the first capacity; and
S433. taking the first sum as the current high-voltage inflection point capacity.

In an embodiment of the present disclosure, the following formula may be used to calculate the current high-voltage inflection point capacity:
${Q}_{HVTP} = {Q}_{soc} + {SOC}_{low} * {Q}_{last}$ (2);
wherein, Q_{HVTP} represents the current high-voltage inflection point capacity, and Q_{soc} represents the first capacity.

In step S2, the current maximum capacity of the battery is determined according to the current high-voltage inflection point capacity.

According to the content, in an embodiment of the present disclosure, the determining the current maximum capacity of the battery according to the current high-voltage inflection point capacity comprises:
S21. acquiring a second capacity charged into the battery from the high-voltage inflection point to full charge; and
S22. determining the current maximum capacity according to the second capacity and the current high-voltage inflection point capacity.

In an embodiment of the present disclosure, the following formula may be used to calculate the current maximum capacity of the lithium iron phosphate lithium-ion battery:
${Q}_{max} = {Q}_{HVTP} + {Q}_{HVP}$ (3);
wherein, Qₘₐₓ represents the current maximum capacity, and Q_{HVP} represents the second capacity.

According to the content, in an embodiment of the present disclosure, the method further comprises:
S5. when the initial static voltage is greater than the preset voltage threshold, determining the current maximum capacity according to a previous high-voltage inflection point capacity of the battery.

In an embodiment of the present disclosure, when the current static voltage is greater than the preset voltage threshold, the previously updated high-voltage inflection point capacity Q_{HVTP} is substituted into formula (3) to calculate the current maximum capacity of the battery.

In summary, the battery capacity determination method of the present disclosure can update the high-voltage inflection point capacity of the battery and determine the current maximum capacity of the battery according to the current high-voltage inflection point capacity, avoiding the problem of large errors in calculating battery capacity using offline battery data, thereby greatly improving the accuracy of the determined battery capacity.

A battery state-of-health determination method according to the embodiment of the present disclosure will be described below referring to FIG. 4, the battery state-of-health determination method may include the following steps:
S61. a current maximum capacity of a battery is determined by a capacity determination method described above; and
S62. a state-of-health of the battery is determined according to a ratio of the current maximum capacity to an initial capacity of the battery.

In an embodiment of the present disclosure, after obtaining the current maximum capacity of the battery using the battery capacity determination method, a ratio of the current maximum capacity to the initial capacity of the battery is calculated, and the battery state-of-health is determined according to the ratio.

In an embodiment of the present disclosure, the ratio may be converted into a percentage, and the percentage may be used as the battery state-of-health parameter. In an embodiment of the present disclosure, when the ratio of the current maximum capacity to the initial capacity of the battery is less than or equal to a preset threshold, prompt information is sent to urge the user to replace or repair the battery.

In summary, the battery state-of-health determination method provided by the present disclosure can, after updating the high-voltage inflection point capacity of the battery, determine the current maximum capacity of the battery according to the updated high-voltage inflection point capacity, and further determine the state-of-health of the battery according to the current maximum capacity of the battery, which can greatly improve the accuracy of the determined state-of-health.

After introducing the battery capacity determination method and the battery state-of-health determination method according to the embodiments of the present disclosure, next, a computer program product according to the embodiments of the present disclosure will be described with reference to FIG. 5. The computer program product may be a computer program product comprising instructions, which, when the computer program product runs on a computer, causes the computer to execute the battery capacity determination method or the battery state-of-health determination method. Referring to FIG. 5, a program product 500 for implementing the above method according to an embodiment of the present disclosure is described, which may be in the form of a portable compact disc read-only memory (CD-ROM) and include program code, and may be run on a device, such as a personal computer. However, the program product of the present disclosure is not limited thereto; herein, a readable storage medium may be any tangible medium that contains or stores a program for use by or in connection with an instruction execution system, apparatus, or device.

The program product may employ any combination of one or more readable media. A readable medium may be a readable signal medium or a readable storage medium. A readable storage medium may be, for example, but not limited to, an electrical, magnetic, optical, electromagnetic, infrared, or semiconductor system, apparatus, or device, or any combination thereof. More specific examples (a non-exhaustive list) of readable storage media include: an electrical connection having one or more wires, a portable disk, a hard disk, random access memory (RAM), read-only memory (ROM), erasable programmable read-only memory (EPROM or flash memory), optical fiber, portable compact disc read-only memory (CD-ROM), optical storage device, magnetic storage device, or any suitable combination of the foregoing.

A computer readable signal medium may include a data signal propagated in baseband or as part of a carrier wave, carrying readable program code therein. Such propagated data signals may take various forms, including but not limited to electromagnetic signals, optical signals, or any suitable combination thereof. A readable signal medium may also be any readable medium other than a readable storage medium that can transmit, propagate, or transport a program for use by or in connection with an instruction execution system, apparatus, or device.

Program code embodied on a readable medium may be transmitted using any appropriate medium, including but not limited to wireless, wired, optical fiber cable, RF, etc., or any suitable combination thereof. Computer program code for carrying out operations of the present disclosure may be written in any combination of one or more programming languages, including an object-oriented programming language such as Java, C++, etc., and conventional procedural programming languages, such as the "C" programming language or similar programming languages. The program code may execute entirely on user computing device, partly on user computing device and partly on a remote computing device, or entirely on the remote computing device or server. In a scenario involving a remote computing device, the remote computing device may be connected to user computing device through any type of network, including a local area network (LAN) or a wide area network (WAN), or may be connected to an external computing device (for example, through the Internet using an Internet Service Provider).

After introducing the computer program product according to the embodiments of the present disclosure, next, a processor according to the embodiments of the present disclosure will be described. The processor is configured to execute instructions to implement the battery capacity determination method or the battery state-of-health determination method. In an embodiment of the present disclosure, the processor may be a chip, an MCU, an integrated circuit, or a terminal device.

After introducing the processor according to the embodiments of the present disclosure, next, a power distribution box according to the embodiments of the present disclosure will be described. The power distribution box comprises the processor, which is disposed within the power distribution box.

After introducing the power distribution box according to the embodiments of the present disclosure, next, a battery management system (BMS) according to the embodiments of the present disclosure will be described. The BMS system comprises the power distribution box, and/or the processor, the power distribution box and/or the processor being disposed within the BMS system.

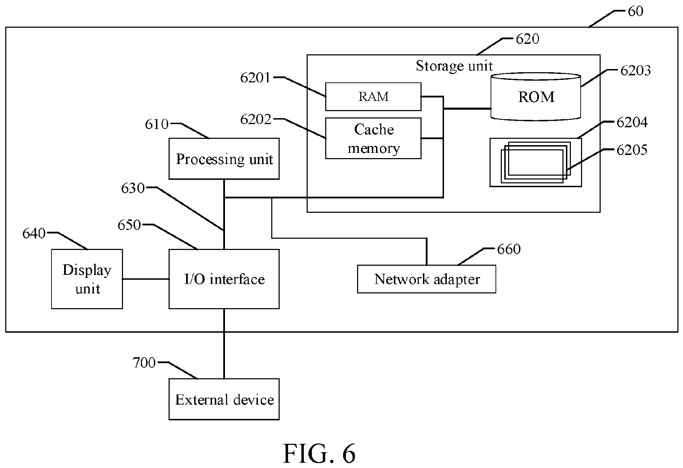

After introducing the BMS system according to the embodiments of the present disclosure, next, an electrical apparatus according to the embodiments of the present disclosure will be described with reference to FIG. 6. The electrical apparatus comprises the BMS system, which is arranged within the electrical apparatus. The electrical apparatus may be a new energy vehicle, an aircraft, a ship, an energy storage cabinet, etc.

The electrical apparatus 60 shown in FIG. 6 is merely an example and will not impose any limitations on the function and scope of use of the embodiments of the present disclosure.

As shown in FIG. 6, the electrical apparatus 60 is embodied in the form of a general-purpose computing device. Components of the electrical apparatus 60 may include, but are not limited to: at least one processing unit 610, at least one storage unit 620, a bus 630 connecting different system components (including the storage unit 620 and the processing unit 610), and a display unit 640. The storage unit stores program code which can be executed by the processing unit 610, causing the processing unit 610 to perform the steps according to the embodiments of the present disclosure described in the "embodiments" section of this specification. For example, the processing unit 610 may execute step S1 and step S2 shown in FIG. 1, or step S61 and step S62 shown in FIG. 4.

The storage unit 620 may include a volatile storage unit, such as random access memory (RAM) 6201 and/or cache memory 6202, and may further include read-only memory (ROM) 6203. The storage unit 620 may also include a program/utility 6204 having a set (at least one) of program modules 6205, including but not limited to: an operating system, one or more application programs, other program modules, and program data, each or some combination of which may include an implementation of a network environment.

The bus 630 may include a data bus, an address bus, and a control bus.

The electrical apparatus 60 may also communicate with one or more external devices 70 (e.g., keyboard, pointing device, Bluetooth device, etc.), and such communication may be via an input/output (I/O) interface 650. The electrical apparatus 60 also includes a display unit 640 connected to the input/output (I/O) interface 650 for display. Furthermore, the electrical apparatus 60 may also communicate with one or more networks (e.g., a local area network (LAN), a wide area network (WAN), and/or a public network such as the Internet) via a network adapter 660. As shown, the network adapter 660 communicates with other modules of the electronic device 60 via the bus 630. It will be understood that, although not shown in the figure, other hardware and/or software modules may be used in conjunction with the electrical apparatus 60, including but not limited to: microcode, device drivers, redundant processing units, external disk drive arrays, RAID systems, tape drives, and data backup storage systems, etc.

Furthermore, although the operations of the method of the present disclosure are described in a specific order in the accompanying drawings, this does not require or imply that these operations must be performed in that specific order, or that all shown operations must be performed to achieve desirable results. Additionally or alternatively, certain steps may be omitted, a plurality of steps may be combined into one step for execution, and/or one step may be decomposed into a plurality of steps for execution.

Although the spirit and principles of the present disclosure have been described with reference to several specific embodiments, it will be understood that the present disclosure is not limited to the disclosed specific embodiments, and the division of various aspects does not mean that features in these aspects cannot be combined for benefit; such division is only for convenience of description. The present disclosure is intended to cover various modifications and equivalent arrangements included within the spirit and scope of the appended claims.

## Claims

1. A battery capacity determination method, comprising:
when an initial static voltage of a battery from which charging starts is less than or equal to a preset voltage threshold value, according to an initial residual capacity corresponding to the initial static voltage and a first capacity charged into the battery from the initial static voltage to a high-voltage inflection point, updating the high-voltage inflection point capacity of the battery to obtain the current high-voltage inflection point capacity of the battery; and
according to the current high-voltage inflection point capacity, determining a current maximum capacity of the battery.

2. The method according to claim 1, wherein updating the high-voltage inflection point capacity of the battery according to the initial residual capacity corresponding to the initial static voltage and the first capacity charged into the battery from the initial static voltage to the high-voltage inflection point comprises:
acquiring the initial residual capacity;
acquiring a previous maximum capacity of the battery; and
determining the current high-voltage inflection point capacity according to the previous maximum capacity, the initial residual capacity, and the first capacity.

3. The method according to claim 2, wherein determining the current high-voltage inflection point capacity according to the previous maximum capacity, the initial residual capacity, and the first capacity comprises:
calculating a product of the previous maximum capacity and the initial residual capacity;
calculating a first sum of the product and the first capacity; and
taking the first sum as the current high-voltage inflection point capacity.

4. The method according to claim 1, wherein determining the current maximum capacity of the battery according to the current high-voltage inflection point capacity comprises:
acquiring a second capacity charged into the battery from the high-voltage inflection point to full charge; and
determining the current maximum capacity according to the second capacity and the current high-voltage inflection point capacity.

5. The method according to claim 1, the method further comprising:
when the initial static voltage is greater than the preset voltage threshold, determining the current maximum capacity according to a previous high-voltage inflection point capacity of the battery.

6. The method according to claim 1, wherein before updating the high-voltage inflection point capacity of the battery according to the initial residual capacity corresponding to the initial static voltage and the first capacity charged into the battery from the initial static voltage to the high-voltage inflection point to obtain the current high-voltage inflection point capacity of the battery, the method further comprising:
acquiring a voltage-capacity curve of the battery during a charging process;
obtaining a filtered voltage-capacity curve by performing smoothing filtering on the voltage-capacity curve;
obtaining a differential voltage-capacity curve by performing a differential operation on the voltage-capacity curve; and
acquiring a peak value of the differential voltage-capacity curve, and determining the high-voltage inflection point according to the peak value.

7. The method according to claim 6, wherein determining the high-voltage inflection point according to the peak value comprises:
acquiring a peak voltage corresponding to the peak value from the voltage-capacity curve;
acquiring a maximum value of the peak voltage; and
taking the maximum value as the high-voltage inflection point.

8. A battery state-of-health determination method, comprising:
determining a current maximum capacity of a battery by a battery capacity determination method according to any one of claims 1 to 7; and
determining a state-of-health of the battery according to a ratio of the current maximum capacity to an initial capacity of the battery.

9. A computer program product comprising instructions, which when the computer program product runs on a computer, cause the computer to execute the battery capacity determination method according to any one of claims 1 to 7 or the battery state-of-health determination method according to claim 8.

10. A processor, the processor is configured to execute instructions to implement the battery capacity determination method according to any one of claims 1 to 7 or the battery state-of-health determination method according to claim 8.

11. A power distribution box, comprising the processor according to claim 10.

12. A BMS system, comprising the power distribution box according to claim 11, and/or comprising the processor according to claim 10.

13. An electrical apparatus, comprising the BMS system according to claim 12.
